(19) **Europäisches Patentamt**
**European Patent Office**
**Office européen des brevets**

(11) **EP 3 198 623 B1**

(12) **FASCICULE DE BREVET EUROPEEN**

(45) Date de publication et mention de la délivrance du brevet:
**28.08.2019 Bulletin 2019/35**

(21) Numéro de dépôt: **15766486.3**

(22) Date de dépôt: **18.09.2015**

(51) Int Cl.:
*H01H 33/668* (2006.01)  *H02B 11/127* (2006.01)

(86) Numéro de dépôt international:
**PCT/EP2015/071495**

(87) Numéro de publication internationale:
**WO 2016/046091 (31.03.2016 Gazette 2016/13)**

(54) **DISPOSITIF SURVEILLANCE DE LA QUALITÉ DU VIDE D'UN DISJONCTEUR À VIDE**

VORRICHTUNG ZUR ÜBERWACHUNG DER VAKUUMQUALITÄT EINES VAKUUMSCHALTERS

DEVICE FOR MONITORING THE VACUUM QUALITY OF A VACUUM CIRCUIT BREAKER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.09.2014 FR 1459067**

(43) Date de publication de la demande:
**02.08.2017 Bulletin 2017/31**

(73) Titulaire: **Schneider Electric Industries SAS 92500 Rueil-Malmaison (FR)**

(72) Inventeurs:
• **SCHELLEKENS, Hans**
  **F-38050 Grenoble Cedex 09 (FR)**
• **GAUTHIER, Jean-Pierre**
  **F-38050 Grenoble Cedex 09 (FR)**
• **CARDOLETTI, Olivier**
  **F-38050 Grenoble Cedex 09 (FR)**
• **DURAND, Maxime**
  **F-38050 Grenoble Cedex 09 (FR)**

(74) Mandataire: **Tripodi, Paul**
  **Schneider Electric Industries SAS**
  **Service Propriété Industrielle**
  **World Trade Center / 38EE1**
  **5 Place Robert Schuman**
  **38050 Grenoble Cedex 09 (FR)**

(56) Documents cités:
**US-A- 4 103 291    US-A- 4 403 124**
**US-A- 5 399 973**

**Description**

**DOMAINE TECHNIQUE**

L'invention concerne un dispositif surveillance de la qualité du vide d'un disjoncteur à vide.

L'invention s'applique plus particulièrement, mais non exclusivement, à des disjoncteurs à vide, notamment triphasés, isolés par un gaz ou par des isolants solides ou par une combinaison de gaz avec une paroi isolante, ou encore sur-isolé (isolant surmoulé).

**ÉTAT DE LA TECHNIQUE ANTÉRIEURE**

La surveillance de la qualité du vide dans des ampoules à vide par des capteurs capacitifs est décrite par exemple le brevet américain US4103291. Dans le dispositif décrit dans ce document, l'ampoule à vide comporte un écran flottant qui forme une première capacité avec un système de contact soumise à la tension du réseau. Une deuxième capacité est créée entre l'écran flottant de l'ampoule à vide et la terre. Le courant qui circule à travers ces capacités fournit une mesure pour l'état du vide de l'ampoule. Ce fonctionnement est fondé sur les caractéristiques diélectriques du vide. Aussi, en cas d'un vide correct la tenue diélectrique est telle qu'aucun amorçage ne se produit à l'intérieur de l'ampoule à vide de sorte qu'un courant capacitif qui traverse cette capacité est proportionnel à la tension du réseau et à la valeur desdites première et deuxième capacités en série. En cas d'un défaut du vide la tenue diélectrique de celui-ci sera réduite et des amorçages à l'intérieur de l'ampoule se produiront mettant l'écran flottant à la tension du réseau. La première capacité entre l'écran et les contacts se trouve court-circuitée et le courant qui traverse la deuxième capacité sera augmenté. Le courant dans la deuxième capacité fournit ainsi une indication sur la qualité du vide dans l'ampoule.

Un des inconvénients de ce dispositif provient de sa sensibilité aux surtensions dans le réseau qui peuvent conduire à une fausse alerte de perte de vide. En outre, l'utilisation d'un tel dispositif nécessite la présence d'un écran flottant à l'intérieur de l'ampoule, ce qui exclut son utilisation pour des ampoules dites asymétriques dépourvues d'écran flottant.

Dans le document EP2463883, un détecteur utilise plusieurs capacités qui surveillent parallèlement le vide et les parties actives du réseau en amont et en aval de l'ampoule. Ainsi, une dégradation de la qualité du vide peut être détectée sous toutes les conditions du réseau pourvu qu'il existe une tension. Dans la réalisation de ce détecteur, une isolation solide avec un écran métallique mis à la terre permet de créer des capacités conséquentes dans lesquelles le courant capacitif est fort.

L'inconvénient des capteurs décrits ci-dessus provient du fait qu'ils ne peuvent pas être appliqués à des disjoncteurs classiques soit à cause d'absence de mesure correcte, soit par absence d'un couplage suffisamment fort pour créer un détecteur autonome, de manière classique. En outre, l'absence d'une isolation blindée oblige à s'éloigner fortement de l'ampoule.

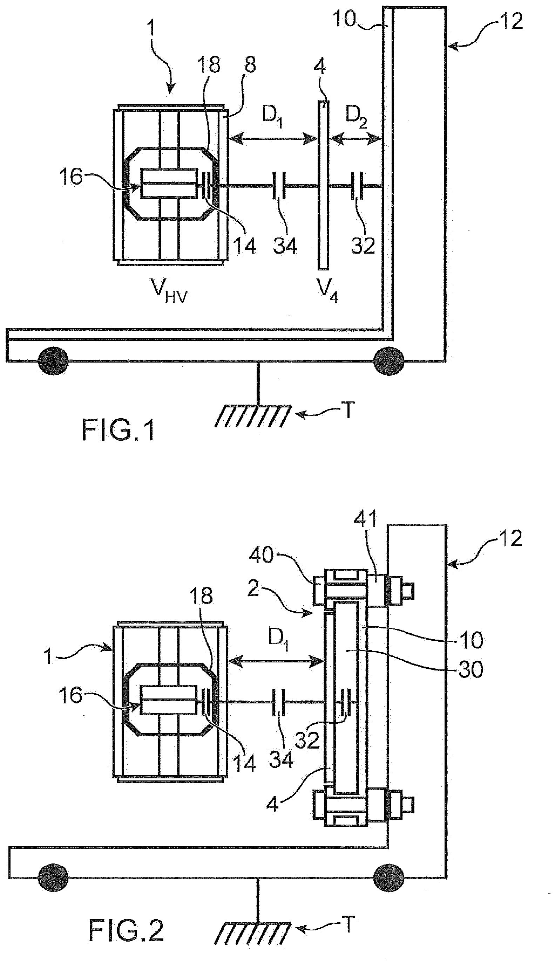

La figure 1 illustre schématiquement le principe d'un dispositif de surveillance de la qualité du vide dans une ampoule à vide 1 d'un disjoncteur de l'art antérieur. La référence 8 est une paroi de l'ampoule à vide 1. Ce dispositif comporte une première surface conductrice 4, agencée entre un écran métallique 18 formant une partie électriquement active de l'ampoule à vide 1 et une deuxième surface conductrice 10 montée mobile sur un chariot 12 relié à la terre T. La première surface conductrice 4 forme une capacité composée de deux capacités en série, soit une capacité 14, dite de vide, formée entre les électrodes 16 de l'ampoule à vide 1 et l'écran métallique 18 entourant les électrodes 16, et une capacité 34, formée entre la surface conductrice 4 et la face extérieure de l'écran métallique 18 qui lui fait face. La surface conductrice 4 forme en outre avec la deuxième surface conductrice 10 une autre capacité 32.

La valeur de capacité 14 est bien définie et dépend de la conception du disjoncteur à vide. Par contre les valeurs des capacités 32 et 34 dépendent des distances D1 et D2 séparant la surface conductrice 4, respectivement de l'écran métallique 18 et de la deuxième surface conductrice 10. Dans ce dispositif, la tension transitoire mesurée au niveau de la surface conductrice 4 dépend des valeurs des capacités 14, 32 et 34 et de la tension de ligne $V_{HV}$ sur les électrodes 16. Comme la valeur de la capacité 14 est beaucoup plus grande que celles des capacités 32 et 34, la majeure partie de la tension $V_{HV}$ est appliquée sur ces capacités 32 et 34.

La répartition de la tension $V_4$ sur la surface conductrice 4 par rapport à la tension de ligne $V_{HV}$ sera proportionnelle au rapport des distances D1 et D2. Les capacités 32 et 34 peuvent être considérées comme résultant de condensateurs à plaques parallèles. Par conséquent, la valeur de la capacité 32 est inversement proportionnelle à la distance D1 et celle de la capacité 34 est inversement proportionnelle à la distance D2. Du fait que la valeur de la capacité 14 est beaucoup plus grande que celle de la capacité 32, elle peut être négligée dans l'approximation. Il en résulte que la tension $V_4$ sur la surface conductrice 4 dépend du rapport D2 / (D1 + D2) et de la haute tension $V_{HV}$ sur les électrodes à l'intérieur du disjoncteur à vide:

$$V_4 \sim \frac{D2}{D1 + D2} * V_{HV}$$

Afin de comprendre les conséquences de cette relation, on considère la condition réaliste suivante: dans un disjoncteur à vide de moyenne tension normale, la distance entre le disjoncteur à vide et le chariot du disjoncteur (D1 + D2) est généralement de 10 cm. La tension $V_{HV}$ est typiquement 10 kV. Afin d'avoir une tension de fonctionnement en toute sécurité sur la surface conductrice 4, à moins de 48 Volts, la distance D2 doit être à 0,5 mm de la plaque 10 de mise à la terre sur le chariot 12 du disjoncteur. Une variation de 5 mm sur la distance de D2 conduira à une tension de 500 volts sur la surface conductrice 4, dépassant d'un facteur 10 le niveau de tension admissible pour l'équipement de mesure basse tension. Il apparaît clairement qu'il est difficile de maintenir une distance sécuritaire de 0,5 mm pour D2 dans des conditions de travail pratique.

L'absence d'une maîtrise des distances D1 et D2 et/ou des capacités 32 et 34, met en péril la mesure et le circuit électronique des manières suivantes :

-    Si la distance D2 entre la surface conductrice 4 et le chariot 12 du disjoncteur est trop petite, la tension transitoire sera faible et trop difficiles à détecter. Ceci ne permet pas de détecter une perte de vide dans l'ampoule du disjoncteur à vide.
-    Si cette distance est trop grande, la tension $V_4$ sur la surface conductrice 4 deviendra trop grande, ce qui peut causer des dommages aux composants électroniques ou créer un court-circuit dans le circuit de mesure. La distance sera affectée par la façon dont la surface conductrice 4 est montée sur le chariot 12.

Un but de l'invention est de pallier les inconvénients de l'art antérieur décrit ci-dessus.

Plus particulièrement, le but de l'invention est un dispositif permettant de détecter, un défaut de vide dans une ampoule à vide d'un disjoncteur sans contact physique avec les parties sous-tension du disjoncteur.

## EXPOSÉ DE L'INVENTION

Le but de l'invention est atteint au moyen d'un dispositif de surveillance de la qualité du vide d'un disjoncteur à vide comportant une première surface conductrice fixe séparée par une couche isolante d'une deuxième surface conductrice fixe de manière à former une première capacité ayant une valeur fixe et un circuit électronique destiné à mesurer une variation de tension sur ladite première capacité représentative d'un changement d'état du vide du disjoncteur. Selon une variante de l'invention, ladite première surface conductrice fixe forme une deuxième capacité fixe avec une partie électriquement active du disjoncteur à vide.

Selon une autre variante de l'invention, l'assemblage rigide est agencé à l'intérieur d'un blindage électrique cylindrique dont au moins une surface extérieure forme une deuxième capacité fixe avec la terre.

La couche isolante est constituée soit par une structure en nid d'abeille, soit par une structure en mousse, soit par une plaque en époxy.

Dans un premier mode de réalisation du dispositif selon l'invention, l'assemblage rigide est réalisé sur un circuit imprimé sur lequel sont gravées la première surface conductrice et la deuxième surface conductrice, séparées par un isolant.

Dans une première variante de ce mode de réalisation, l'assemblage rigide est monté sur un chariot mobile relié à la terre.

Dans une deuxième variante, l'assemblage rigide est agencé à l'intérieur d'un blindage électrique cylindrique entourant le disjoncteur à vide, ledit blindage étant relié à la deuxième surface conductrice, ladite première surface conductrice étant reliée à un écran métallique formant ladite partie électriquement active de l'ampoule à vide, et, la deuxième capacité est formée entre la surface extérieure du blindage électrique et la terre.

Dans une autre variante, l'assemblage rigide peut être fixé comme un « patch » sur la surface externe de l'ampoule à vide en contact électrique avec ladite partie électriquement active.

Le dispositif selon l'invention permet de surveiller la qualité du vide d'un disjoncteur à vide triphasé. Dans ce cas, pour chaque phase, il comporte ledit assemblage rigide. Ce dernier comporte en outre une capacité supplémentaire agencée de manière à récupérer un courant pour alimenter le circuit électronique destiné à détecter un changement d'état du vide.

## BRÈVE DESCRIPTION DES DESSINS

D'autres caractéristiques et avantages de l'invention ressortiront de la description qui va suivre, prise à titre d'exemple non limitatif, en référence aux figures annexées dans lesquelles:

-    la figure 1, décrite précédemment, illustre schématiquement le principe d'un dispositif de surveillance de la qualité du vide d'un disjoncteur à vide de l'art antérieur,
-    la figure 2 illustre schématiquement un premier mode de réalisation d'un dispositif de surveillance de la qualité du vide d'un disjoncteur à vide selon l'invention,
-    la figure 3 illustre schématiquement un deuxième mode de réalisation d'un dispositif de surveillance de la qualité du vide d'un disjoncteur à vide selon l'invention,
-    la figure 4 illustre schématiquement un troisième mode de réalisation d'un dispositif de surveillance de la qualité du vide d'un disjoncteur à vide selon l'invention,
-    la figure 5 est une courbe illustrant la variation de la tension de tenue diélectrique dans un disjoncteur industriel à vide.

## EXPOSÉ DÉTAILLÉ DE MODES DE RÉALISATION PARTICULIERS

Pour plus de clarté, des références identiques désigneront les éléments du dispositif de l'art antérieur de la figure 1 et les dispositifs selon l'invention.

Sur la figure 2 est illustré schématiquement un disjoncteur à vide composé d'un chariot 12 et au moins une ampoule à vide 1 et un assemblage rigide 2 formant un détecteur des variations de l'état du vide de l'ampoule 1. Ce détecteur comporte une première surface conductrice fixe 4 séparée par une couche isolante 30 d'une deuxième surface conductrice fixe 10 reliée à la terre T. L'assemblage rigide 2 constitué par la première surface conductrice fixe 4, et la deuxième surface conductrice fixe 10 forme une première capacité 32 ayant une valeur fixe. L'ensemble rigide ainsi constitué est monté sur le chariot 12 et agencé de sorte que la première surface conductrice fixe 4 soit en vis-à-vis d'une partie électriquement active 18 du disjoncteur à vide. La première surface conductrice fixe 4 forme ainsi avec cette partie électriquement active 18 une deuxième capacité 34. Un circuit électronique, non représenté, est relié à l'assemblage rigide 2 pour mesurer les variations de courant dans la première capacité 32 et la deuxième capacité 34 et fournir une indication de l'état du vide de l'ampoule 1 en fonction du résultat des mesures.

La connexion à la terre de la deuxième surface conductrice fixe 10 est réalisée au moyen d'un boulon ou d'un rivet 40 enserrant la couche isolante 30 et le reliant solidement au chariot 12. Une pièce de séparation 41 fixée sur le boulon 40 permet de maintenir une distance suffisante entre l'assemblage rigide 2 et les composants électroniques montés sur le circuit de détection installé sur le chariot 12. En raison de la rigidité de l'assemblage obtenu, la capacité 32 présente une valeur fixe. L'épaisseur de la couche isolante 30 est comprise entre 0,1 et 10 mm. Une valeur trop faible augmente excessivement la valeur de la capacité 32 et réduira inutilement la valeur de la tension transitoire mesurée sur la première surface conductrice fixe 4.

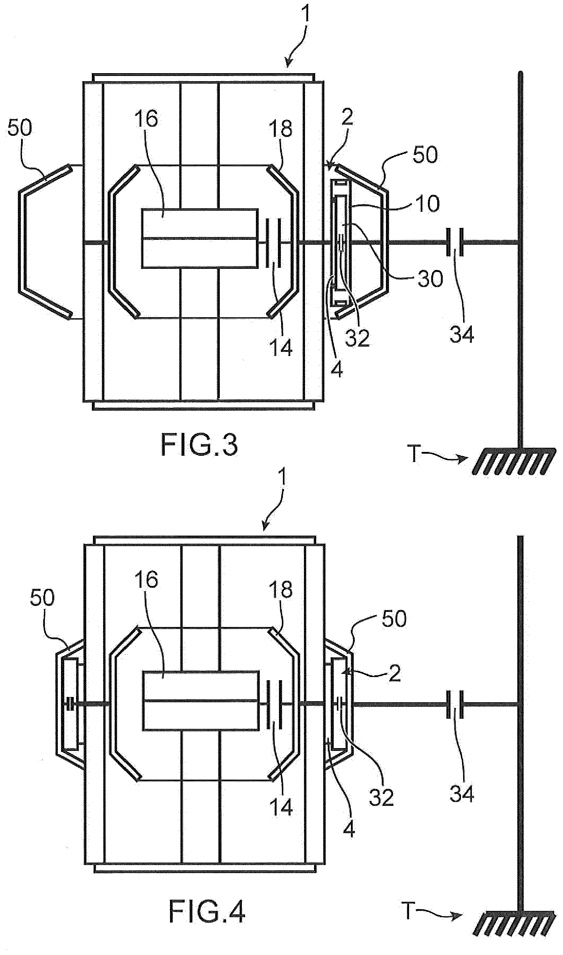

La figure 3 illustre un deuxième mode de réalisation de l'invention dans lequel l'assemblage rigide 2 est agencé à l'intérieur d'un blindage électrique cylindrique 50 entourant l'ampoule à vide 1. Ledit blindage est relié à la deuxième surface conductrice 10 et la première surface conductrice 4 est reliée à la partie électriquement active 18 de l'ampoule à vide. La deuxième capacité 34 est formée entre la surface extérieure du blindage électrique 50 et la terre.

L'assemblage ainsi réalisé peut être appliqué sur la surface externe de l'ampoule à vide 1 autour de l'écran métallique 18, comme un « patch » comme cela est illustré par la figure 4. La surface conductrice 4 est en contact électrique direct avec la partie électriquement active 18.

En raison du contact direct avec l'écran métallique 18, le système peut être autoalimenté.

En fonctionnement, la tension de la première capacité 32 $V_{32}$ est utilisée pour surveiller l'état du vide du disjoncteur à vide. Dans le cas d'un disjoncteur à vide ayant un bon niveau de vide, la chaîne de condensateurs 14, 32 et 34 permet de déterminer le courant circulant dans ces capacités, et d'en déduire la tension $V_{32}$ par la formule suivante :

$$V_{32} = \frac{1/C_{32}}{\left(\dfrac{1}{C_{14}} + \dfrac{1}{C_{34}} + \dfrac{1}{C_{32}}\right)} * V_{HV}$$

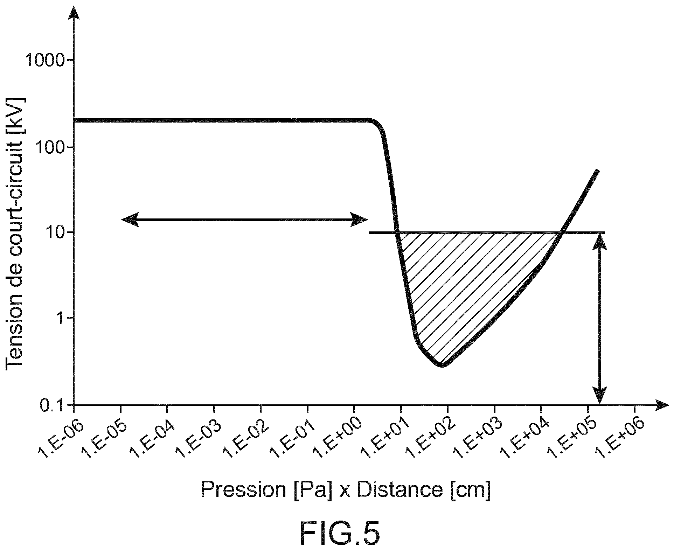

Dans le cas d'un disjoncteur avec un défaut de vide, la pression dans l'ampoule à vide du disjoncteur augmente régulièrement et la rigidité diélectrique du disjoncteur à vide suit la loi Paschens comme illustré par la figure 5.

Lorsque le niveau du vide dans le disjoncteur atteint une valeur dite « Minimum de Paschen », la rigidité diélectrique est inférieure à la tension de réseau. Cela provoque des court-circuits entre les électrodes 16 et l'écran métallique 18. La capacité 14 est alors court-circuitée entraînant une augmentation du courant circulant à travers la chaîne restante des capacités 32 et 34. La tension $V_{32}$ varie alors de la manière suivante:

$$V_{32} = \frac{1/C_{32}}{\left(\dfrac{1}{C_{32}} + \dfrac{1}{C_{34}}\right)} * V_{HV}$$

Il en résulte que la tension V32 augmente en présence d'un défaut de vide dans l'ampoule à vide 1.

**Revendications**

1. Dispositif de surveillance de la qualité du vide d'un disjoncteur à vide **caractérisé en ce qu'**il comporte :

   - au moins un assemblage rigide (2) comportant une première surface conductrice fixe (4) séparée par une couche isolante (30) d'une deuxième surface conductrice fixe (10) de manière à former une première capacité (32) ayant une valeur fixe,
   - un circuit électronique destiné à mesurer une variation de tension sur ladite première capacité (32) représentative d'un changement d'état du vide du disjoncteur, et **caractérisé en ce que** ladite première surface conductrice fixe (4) forme une deuxième capacité fixe (34) avec une partie électriquement active (18) du disjoncteur à vide.

2. Dispositif de surveillance de la qualité du vide d'un disjoncteur à vide **caractérisé en ce qu'**il comporte :

   - au moins un assemblage rigide (2) comportant une première surface conductrice fixe (4) séparée par une couche isolante (30) d'une deuxième surface conductrice fixe (10) de manière à former une première capacité (32) ayant une valeur fixe,
- un circuit électronique destiné à mesurer une variation de tension sur ladite première capacité (32) représentative d'un changement d'état du vide du disjoncteur, et **caractérisé en ce que** l'assemblage rigide (2) est agencé à l'intérieur d'un blindage électrique cylindrique (50) dont au moins une surface extérieure forme une deuxième capacité fixe (34) avec la terre.

## Patentansprüche

1. Vorrichtung zur Überwachung der Vakuumqualität eines Vakuumschalters, **dadurch gekennzeichnet, dass** er aufweist:

   - mindestens eine starre Baugruppe (2), die eine erste feste leitfähige Fläche (4) aufweist, die durch eine isolierende Schicht (30) von einer zweiten festen leitfähigen Fläche (10) derart getrennt ist, um eine erste Kapazität (32) zu bilden, die einen festen Wert aufweist,
   - eine elektronische Schaltung, die dazu bestimmt ist, eine Spannungsänderung an der ersten Kapazität (32) zu messen, die für eine Zustandsänderung des Vakuums des Schalters repräsentativ ist, und
   **dadurch gekennzeichnet, dass** die erste feste leitfähige Fläche (4) eine zweite feste Kapazität (34) mit einem elektrisch aktiven Teil (18) des Vakuumschalters bildet.

2. Vorrichtung zur Überwachung der Vakuumqualität eines Vakuumschalters, **dadurch gekennzeichnet, dass** er aufweist:

   - mindestens eine starre Baugruppe (2), die eine erste feste leitfähige Fläche (4) aufweist, die durch eine isolierende Schicht (30) von einer zweiten festen leitfähigen Fläche (10) derart getrennt ist, um eine erste Kapazität (32) zu bilden, die einen festen Wert aufweist,
   - eine elektronische Schaltung, die dazu bestimmt ist, eine Spannungsänderung an der ersten Kapazität (32) zu messen, die für eine Zustandsänderung des Vakuums des Schalters repräsentativ ist, und
   **dadurch gekennzeichnet, dass** die starre Baugruppe (2) im Inneren einer zylindrischen elektrischen Abschirmung (50) angeordnet ist, wovon mindestens eine Außenfläche eine zweite feste Kapazität (34) mit der Erde bildet.

## Claims

1. Device for monitoring the vacuum quality of a vacuum circuit-breaker, **characterized in that** it comprises:

   - at least one rigid assembly (2) comprising a first stationary conductive surface (4) that is separated by an insulating layer (30) from a second stationary conductive surface (10), thus forming a first capacitor (32) having a set value,
   - an electronic circuit for measuring a variation in the voltage on said first capacitor (32) that is representative of a change in state of the vacuum of the circuit-breaker, and
   **characterized in that** said first stationary conductive surface (4) forms a second fixed capacitor (34), in combination with an electrically active element (18) of the vacuum circuit-breaker.

2. Device for monitoring the vacuum quality of a vacuum circuit-breaker, **characterized in that** it comprises:

   - at least one rigid assembly (2) comprising a first stationary conductive surface (4) that is separated by an insulating layer (30) from a second stationary conductive surface (10), thus forming a first capacitor (32) having a set value,
   - an electronic circuit for measuring a variation in the voltage on said first capacitor (32) that is representative of a change in state of the vacuum of the circuit-breaker, and
   **characterized in that** the rigid assembly (2) is arranged on the interior of a cylindrical electric shielding (50), at least one exterior surface of which forms a second fixed capacitor (34), in combination with ground.

FIG.1

FIG.2

FIG.3

FIG.4

FIG.5

## RÉFÉRENCES CITÉES DANS LA DESCRIPTION

### Documents brevets cités dans la description

- US 4103291 A
- EP 2463883 A